# EUROPEAN PATENT SPECIFICATION

(11) **EP 4 556 148 B1**
(45) Date of publication and mention of the grant of the patent: **17.12.2025**
(21) Application number: 24197023.5
(22) Date of filing: 28.08.2024
(51) Int. Cl.: G06Q 10/04, B23D 59/00, B27B 1/00, G06F 30/20, G06Q 50/02

(54) **COMPUTER-IMPLEMENTED METHOD TO PROVIDE A CUTTING PATTERN FOR A TREE LOG TO OBTAIN WOODEN BOARDS, APPARATUS AND A TRAINING METHOD**
COMPUTERIMPLEMENTIERTES VERFAHREN ZUR BEREITSTELLUNG EINES SCHNEIDMUSTERS FÜR EIN BAUMSTAMM ZUM ERHALT VON HOLZBRETTERN, GERÄT UND AUSBILDUNGSVERFAHREN
PROCÉDÉ MIS EN OEUVRE PAR ORDINATEUR POUR FOURNIR UN MOTIF DE COUPE POUR UNE BILLE D'ARBRE AFIN D'OBTENIR DES PLANCHES EN BOIS, APPAREIL ET PROCÉDÉ D'ENTRAÎNEMENT

(30) Priority: 16.11.2023 IT 202300024351
(43) Date of publication of application: 21.05.2025
(73) Proprietor: MICROTEC S.p.A., 39042 Bressanone (BZ) (IT)
(72) Inventor: VICARIO, Enrico, 30030 MARTELLAGO VE (IT); URSELLA, Enrico, 30174 MESTRE VE (IT)
(74) Representative: Marchi, Paolo

(56) References cited:
- WO-A2-02/068899
- US-A1- 2021 089 902
- US-A1- 2023 125 887
- US-A1- 2023 131 223

## Description

The present invention arises in the timber sector and specifically concerns a computer-implemented method to provide a cutting pattern for a tree log to obtain wooden boards. The use of a cutting pattern for cutting a log is already known in the timber and sawmill manufacturing sector.

Basically, a cutting pattern indicates where the log is to be cut to produce boards. If we consider a log extending along a longitudinal axis and the boards to be obtained having a minor face lying in a plane transverse to the longitudinal axis and having elongated faces that are substantially parallel to the longitudinal axis, the cutting pattern comprises a set of positions of cuts substantially parallel to the longitudinal axis for obtaining the elongated faces of the boards.

The prior art already recognises the possibility of optimising the cutting pattern based on the log's outer shape and defects to maximise the yield of boards obtained from cutting the log. For this purpose, the prior art has already proposed the computed tomography scanning of the log to obtain information on the log's structure and defects so that this information can be used to optimise the cutting pattern. An example is disclosed in WO 02/068899 A2; see also US 2021/0089902 A1.

The introduction of computed tomography scanning of the log, by providing information on the internal structure of the log before cutting, increases the potential advantages of optimisation because it allows to take into account defects that are not visible or quantifiable from a purely outer examination of the log.

At the same time, however, the computational complexity of the optimisation increases significantly. Indeed, for each of the possible cutting patterns to be evaluated, it is required to intersect the possible virtual boards with the three-dimensional model of the log obtained from the tomography scan, to examine how the defects are positioned along each virtual board of the possible cutting pattern, and to estimate how well each virtual board meets the quality criteria considered for the optimisation. For example, an optimisation of a cutting pattern according to prior-art computational techniques may involve evaluating millions of virtual boards.

The considerable computational effort required poses serious problems in terms of computation time and in terms of being able to obtain an optimised cutting pattern in a time compatible with manufacturing requirements in a sawmill.

In an effort to resolve these issues, approximations of evaluation rules have previously been proposed in order to speed up the optimisation. However, these approximations carry a risk of major inconsistencies relative to reality and, therefore, can lead to a cutting pattern that is not optimised at all.

Computer-implemented methods that use artificial neural networks to provide information about the structure and/or the defects of timber boards have also been proposed, for example see US 2023/0131223 A1 which discloses the preamble of claim 1, and US 2023/0125887 A1. However these methods are not useful for optimising the cutting pattern of a tree log and, in particular, for reducing the computational complexity of the optimisation.

In this context, the technical purpose of the present invention is to produce a computer-implemented method to provide a cutting pattern, where the method requires less computational effort than the prior art described above and allows the cutting pattern to be optimised in a shorter time, or at least offers an alternative to currently known methods.

The technical purpose is substantially achieved by a method to provide a cutting pattern in accordance with independent claim 1. Particular embodiments are defined in the corresponding dependent claims. The present invention also relates specifically to a cutting apparatus comprising a computer configured to implement the method to provide the cutting pattern, as defined in claim 13, and to a training method to train a convolutional neural network to be used in the method to provide the cutting pattern, as defined in claim 14.

According to one aspect of the present invention, for the optimisation, the method provides one or more value maps for a cross-section (or multiple cross-sections, where appropriate) of a three-dimensional model of the log. The value map correlates to information about features of the structure of the log and/or about the defects of the log, that is, the value map can be obtained from the three-dimensional model of the log. To each point of the cross-section, the value map assigns a value of the virtual board that has its minor face centred at said point (or at another predetermined positional relationship, such as having its bottom left corner at that point), with set orientation and set dimensions, and that extends along the longitudinal axis of the log.

In other words, at each point of the cross-section the value map summarises a numerical value representing the quality of the board - with the predetermined dimensions for the value map - that has its minor face centred at that point (or has another predetermined positional relationship). For example, the cross-section considered for the value map corresponds to the end face of the log and the virtual board can extend along the entire length of the log along the longitudinal axis.

Therefore, during the optimisation of the cutting pattern, the computation of the objective function to be optimised uses the value map to compute the value of a virtual board which has the predetermined orientation and dimensions for the value map and which, according to the cutting pattern to be evaluated, has its minor face centred (or having another predetermined positional relationship) at a point of the value map.

This constitutes a significant computational simplification because the value map, once obtained, immediately provides information for the virtual board which, in the prior art, is laboriously obtained by intersecting the virtual board with the three-dimensional model of the log, by examining the positions of the defects and by estimating how well the virtual board meets the quality criteria considered for the optimisation.

In one specific embodiment, the three-dimensional model of the log is obtained from a computed tomography scan of the log. In other embodiments, the three-dimensional model of the log is obtained through other techniques, such as through a camera vision system or more generally through a measurement system that allows information about the log's defects to be obtained.

In specific embodiments, the method according to the invention involves providing a plurality of value maps concerning different orientations and/or different dimensions of the minor face of the board. This is useful if the optimisation concerns not only the position of the cuts to be made, but also the dimensions of the boards and/or whether the log can be rotated relative to the cutting tools.

In one embodiment, the value map is obtained from a defect map of the log and/or from a shape map of the log. These maps are images which are derived from the three-dimensional model of the log and which relate to a log section of a predetermined length. The defects (in particular, the internal defects) of the log section are represented in the defect map and the circumferential profiles of the log are represented in the shape map. In practice, the defect map and the shape map show the projection of the defects and of the circumferential profiles, respectively, onto a cross-section of the log section: information present along the entire length of the log section, such as the number of intersected knots and their length, is collected and "condensed" onto the cross-section's two-dimensional surface. Since these maps are projections (in a broad sense), they can easily be obtained from the three-dimensional model of the log.

In one specific embodiment, a convolutional neural network is used to provide the value map from the defect map of the log and/or from the shape map of the log. This is useful because, once the convolutional neural network has been suitably trained, the value map is very quickly computed from the three-dimensional model of the log.

Further features and the advantages of the present invention will become more apparent from the following detailed description of one preferred non-limiting embodiment thereof. Reference shall be made to the accompanying drawings, in which:
- Figure 1 schematically illustrates a step of performing a computed tomography scanning of a log, the step forming part of a method according to the present invention;
- Figure 2 shows some cross-sections of a three-dimensional model of the log, obtained from the computed tomography scanning in Figure 1;
- Figure 3 shows a virtual board within the three-dimensional model of the log;
- Figure 4 shows an elongated face of a board corresponding to the virtual board in Figure 3;
- Figure 5 and Figure 6 show examples of cutting patterns of a log, in a side view and in a cross-section of the log, respectively;
- Figure 7 schematically shows the idea underlying a value map according to the present invention;
- Figure 8 shows some examples of value maps of a log;
- Figure 9 shows a longitudinal section of the three-dimensional model of the log, where successive log sections are highlighted;
- Figure 10 and Figure 11 show a defect map and a shape map, respectively, to be used in an embodiment of the present invention;
- Figure 12 schematically illustrates how a value map is obtained using a convolutional neural network, according to an embodiment of the present invention;
- Figure 13 shows a block diagram of the training method to train the convolutional neural network;
- Figures 14 to 17 show comparisons between value maps used to train the convolutional neural network and corresponding value maps computed by the convolutional neural network, where the value map for training is the image on the left and the computed value map is the image on the right;
- Figure 18 shows a block diagram of an embodiment of the method to provide a cutting pattern according to the present invention;
- Figure 19 shows a diagram of reinforcement machine learning that can be employed in a method according to the present invention.

As mentioned above, the present invention relates to a computer-implemented method to provide a cutting pattern for a tree log to obtain wooden boards. In the drawings, the log is indicated with reference number 1 and a wooden board is indicated with reference number 2.

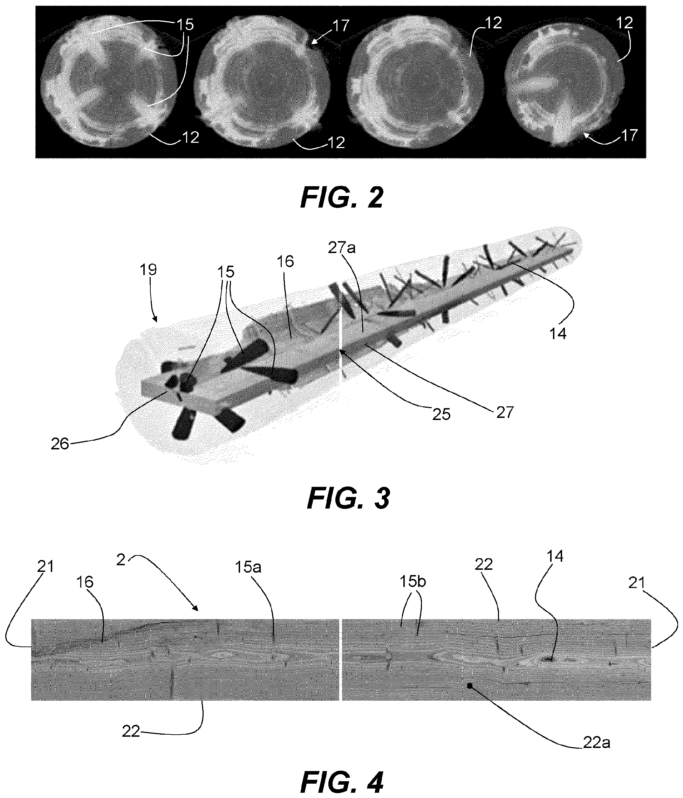

The log 1 extends along a longitudinal axis 10, albeit with some approximation due to the fact that the log 1 is of natural origin and its growth is not along an exact straight line. Each board 2, having a basically parallelepiped shape, has two minor faces 21 (having the width and thickness of the board, i.e. the smaller dimensions of the board) and four elongated faces 22 (having the length of the board, i.e. the larger dimension of the board, and one of the smaller dimensions). Figure 4 shows one of the elongated faces 22, specifically an elongated face 22a having the largest dimensions, while the minor faces 21 and two other elongated faces 22 are perpendicular to the plane of the page and only their upper edge is shown in Figure 4.

The cutting pattern indicates how the log 1 is to be cut to obtain the desired products, specifically a set of boards 2 which may have different dimensions from each other.

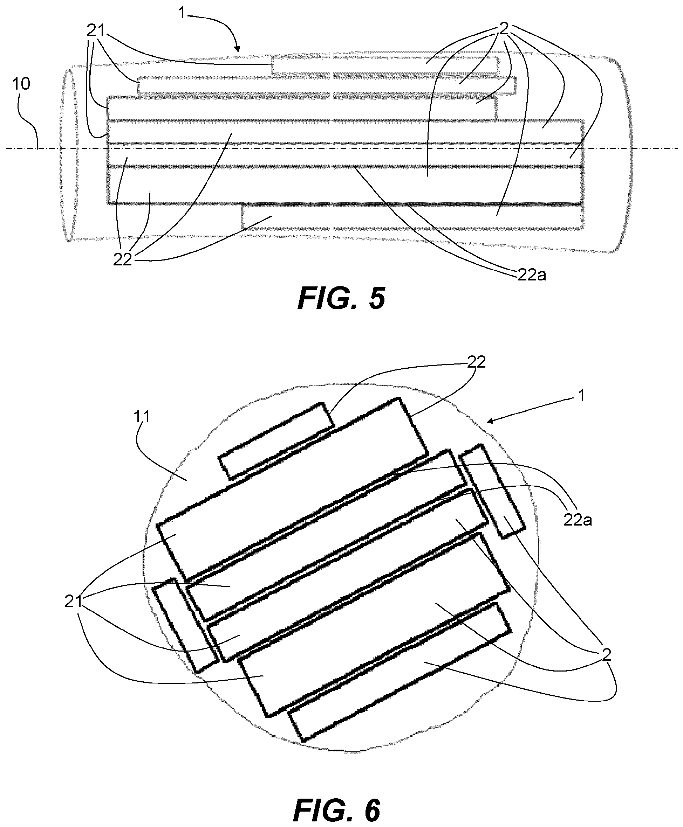

The present invention relates to a cutting pattern relating to boards 2 each having a minor face 21 lying in a plane transverse to (in particular, in a plane perpendicular to) the longitudinal axis 10 of the log 1 and elongated faces 22 (in particular, the faces 22a with the largest dimensions) that are substantially parallel to the longitudinal axis 10 of the log 1. The cutting pattern therefore comprises a set of positions of cuts substantially parallel to the longitudinal axis 10 for obtaining the elongated faces 22 of the boards 2. See Figures 5 and 6, where boards 2 are shown within the log 1 at the points where they were obtained; these figures thus represent the cutting pattern of the log 1 for obtaining the boards 2.

The example in Figure 6 shows the positions of the cuts on a transverse end face 11 of the log 1. The cutting pattern may also comprise a set of positions of cuts along planes transverse (in particular, perpendicular) to the longitudinal axis 10 to obtain the minor faces 21 of the boards 2; the boards 2 may have different lengths, as per the example in Figure 5.

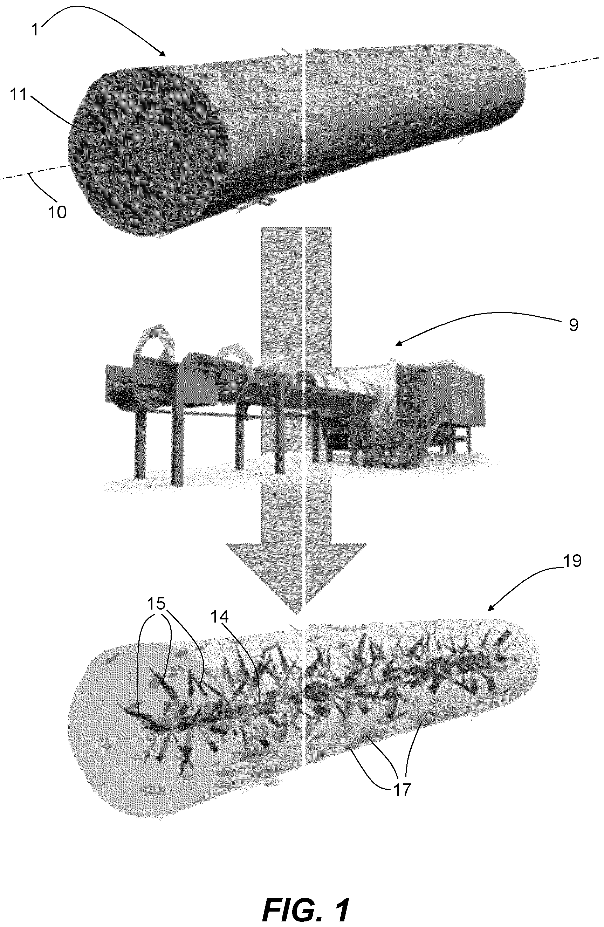

One embodiment of the method according to the present invention first of all comprises a step of performing a computed tomography scanning of the log 1 to obtain a three-dimensional model of the log 1. This is shown schematically in Figure 1: a log 1 is scanned in a computed tomography scanner 9, which provides a three-dimensional model 19 (in digital format). The three-dimensional model 19 contains information about features of a structure of the log 1 (e.g. its outer shape and the location of the pith 14) and/or about defects of the log 1 (such as external defects 17, knots 15, other internal defects such as cracks or fissures). Figure 2 shows four cross-sections of an example of a three-dimensional model 19 in which knots 15 can be seen extending radially in depth, and defects 17 such as hollows and missing parts can be seen in the outer region of the log.

Specifically, computed tomography scanning uses x-rays. The step of computed tomography scanning the log 1 is already known *per se* in the prior art and it does not seem necessary to provide further details on this.

In other embodiments of the method according to the present invention, the step of obtaining the three-dimensional model of the log 1 is implemented not by tomography scanning, but by another measurement system that allows information to be obtained about the features of the structure of the log and/or about the defects of the log. One example of an alternative measurement system is a camera vision system which determines only the outer shape of the log 1 (where the features are the outer shape itself and the defects may include deviations from a circular cross-section) and/or which also sees other defects such as cracks (the extent of those cracks in the log can be estimated).

Figure 3 shows the three-dimensional model 19 of the log 1 and a virtual board 25 therein. The virtual board 25 represents the actual board 2 that would be obtained from the log 1 by cutting the latter along the same planes defined by the faces of the virtual board 25 in the three-dimensional model 19 of the log 1 itself. Because the planes intersect the structure and the defects of the log, it is possible to compute from the three-dimensional model 19 how the features and/or the defects are positioned in the virtual board 25 and, therefore, in the actual board 2.

In other words, the virtual board 25 corresponds to the board 2 that would actually be obtained in terms of its shape and defects, within the accuracy of the three-dimensional model 19 and the precision of a cutting device to be used to cut the log 1.

Figure 4, for example, shows the actual board 2 corresponding to the virtual board 25: in the actual board 2, the pith 14, live knots 15a, dead knots 15b and cracks 16 are seen to be present. These defects and their position can be predicted in advance by intersecting the corresponding virtual board 25 with the three-dimensional model 19.

It should be kept in mind that, even in the simplest case where only the outer shape of the log 1 is determined and only this is considered for processing the cutting pattern, defects in the actual board 2 may be the bevel edges, which are caused not by specific defects in the log 1 but by the natural outer shape of the log 1 and by how the respective virtual board 25 is positioned relative to the natural outer shape of the log 1. The outer shape is part of the "features of the structure of the log" that may be considered in the method according to the present invention, and the bevel edges can also be predicted in advance by intersecting the corresponding virtual board 25 with the three-dimensional model 19.

The knots can alternately be considered as defects or as features of the structure of the log, but in any case this does not change the substance of the method according to the present invention, in which information about the features of the structure of the log is used in combination with or as an alternative to information about the defects of the log. Since the virtual board 25 represents the corresponding actual board 2, the virtual board 25 also has minor faces 26 that correspond to the minor faces 21 of the board 2 and elongated faces 27 (specifically, faces 27a with the largest dimensions) that correspond to the elongated faces 22 of the board 2.

The method according to the present invention also comprises a step of computer-processing of the three-dimensional model 19 of the log 1 to determine the cutting pattern: during this processing, a plurality of combinations of possible positions of cuts substantially parallel to the longitudinal axis 10 of the log 1 are considered and a value of an objective function is computed for each combination of possible positions of the cuts. The objective function takes into account how the defects of the log 1 are positioned in the virtual boards 25 according to the combination of possible positions of the cuts. As mentioned above, the virtual boards 25 represent the boards 2 that can be obtained from cutting the log 1 according to the combination of the possible positions of the cuts and, therefore, the size features and the defect-related features of the boards 2 can be estimated from the respective virtual boards 25. The cutting pattern, which is to say the set of the positions of the cuts to be made in the log 1, is selected from the plurality of combinations of possible positions of the cuts through the optimisation of the objective function.

The prior art recognises methods for the computer-processing of the three-dimensional model of the log to determine the cutting pattern through optimisation of an objective function. As indicated above, these methods have considerable computational complexity and require long computation times.

The method according to the present invention proposes computerised-processing of the three-dimensional model of the log that allows the cutting pattern to be determined more easily and quickly, as described below.

The step of the computer-processing of the three-dimensional model 19 of the log 1 comprises a first sub-step that sets an orientation and the dimensions of a minor face 26 of a virtual board 25.

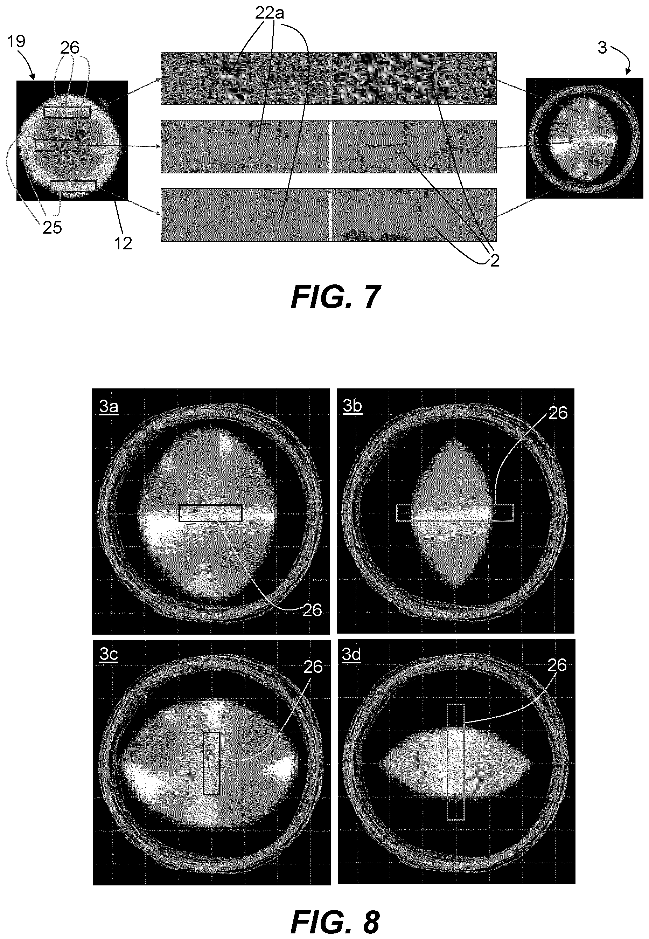

The dimensions of the minor face 26 are the width and thickness of the virtual board 25. The minor face 26 of the virtual board 25 lies in a plane transverse to (in particular, in a plane perpendicular to) the longitudinal axis 10 of the log 1, and the elongated faces 27 of the virtual board 25 are substantially parallel to the longitudinal axis 10 of the log 1. The "orientation" of the minor face 26 refers to how the minor face 26 is rotated in the transverse plane, which is to say the angle that one side of the minor face 26 (for example, the side corresponding to the width of the virtual board 25) forms with a reference axis on the transverse plane. See Figure 8, in which the top images show the minor face 26 with a first orientation and the bottom images show the minor face 26 with a second orientation that is rotated 90° relative to the first orientation.

Basically: by setting the dimensions of the minor face 26 of the virtual board 25, it is taken into consideration a corresponding board 2 that can be obtained from the log 1 and that has the minor face 21 with the same dimensions as the virtual minor face 26; by setting the orientation of the minor face 26, it is taken into consideration the relative angular position that a blade of the cutting device must assume relative to a reference axis on the transverse end face 11 of the log 1 to obtain the corresponding board 2. The step of the computer-processing of the three-dimensional model 19 of the log 1 also comprises a second sub-step that, for a cross-section 12 of the three-dimensional model 19 of the log 1 that is transverse (in particular, perpendicular) to the longitudinal axis 10 of the log 1, provides a value map 3 for the virtual board 25 having its minor face 26 with the set orientation and the set dimensions. Said value map 3, which correlates to information about the features of the structure and/or about the defects of the log 1, assigns to each point on the cross-section 12 a value of the virtual board 25 having its minor face 26 centred at that point. As described above, the cross-section 12 corresponds, for example, to the transverse end face 11 of the log 1 and the virtual board 25 can extend along the entire length of the log 1 along the longitudinal axis 10, if the outer shape of the log 1 allows it.

This concept is illustrated in Figure 7. The image on the left shows a cross-section 12 of the three-dimensional model 19 of the log, where the minor faces 26 of three different virtual boards 25 are shown, having the set dimensions and orientation. The largest elongated faces 22a of the actual boards 2 corresponding to the virtual boards 25 are shown in the central images, where defects can also be seen. The image on the right shows the value map 3 for the cross-section 12, where, in particular, the arrows indicate the three points corresponding to the three virtual boards 25. It can be seen that the values in the value map 3 are represented graphically in grayscale, but they correspond to specific numerical values (for example, 3.20; 5.80; 4.30).

Basically, the value map provides a function that, for the cross-section 12 and for the set dimensions and orientation, assigns the coordinates of each point in the cross-section 12 a numerical value of the "value" of the corresponding virtual board 25 and, therefore, of the corresponding actual board 2. Information about the features of the structure of the log 1 and/or about the defects of the log 1 that would be present in the corresponding board 2 is condensed and summarised in the numerical value given by the value map. It can also be seen that in the value map 3 shown the outer contour of the log is also reproduced and there are black areas (that is, zero-value areas) that correspond to points for which the board 2 would not be obtainable because it would go outside the outer contour of log 1.

The value maps in Figures 7 and 8 concern, as mentioned above, virtual boards 25 that have their minor face 26 centred at the respective points on the value map; which is to say, each point of the value map represents the value of a virtual board 25 having its minor face 26 with this point at the centre of the minor face 26 itself. In alternative embodiments, the value map concerns virtual boards 25 that have their minor face 26 in another predetermined positional relationship with the respective point: for example, each point of the value map represents the value of a virtual board 25 having its minor face 26 with its lower left corner at said point.

As regards the "value" considered in value map 3, this is, for example, the commercial value (basically, a sale price) that can be estimated for the actual board 2 corresponding to the virtual board 25, taking into account how the defects and their specific positions affect the commercial value. For this purpose, mathematical formulas can be used to compute a commercial value based on the knot size and/or the number of knots per unit length. In addition or alternatively, the "value" takes into account whether or not the virtual board complies with certain preset rules, such as a maximum permissible knot size and/or a maximum number of knots per unit length. The rules may also include the possibility of shortening the board, by removing any defects present at its head or tail, to increase its value. In particular, if, for a point of the cross-section 12, the value of the respective virtual board 25 increases by considering a board that is shorter and/or differently positioned along the longitudinal axis 10 instead of the virtual board with the maximum length, the value assigned to that point in the value map 3 is the highest obtainable value. In other words, management of the length and longitudinal position of the boards is delegated to the value map processing stage, wherein the best value obtainable for each point of the cross-section 12 is evaluated.

The step of the computer-processing of the three-dimensional model 19 of the log 1 comprises a third sub-step that optimises the objective function, wherein the computation of the objective function uses the value map 3 to compute the value of a virtual board 25 that has its minor face 26 - with said set orientation and set dimensions - at the cross-section 12.

In other words: during the computer-processing of the three-dimensional model 19 of the log 1 to determine the cutting pattern of the log 1 through the optimisation of the objective function, the values to be entered in the objective function are obtained by querying the value map 3 at the points of interest. This turns out to be much easier and faster than determining the values to be entered by means of a processing that each time requires intersection of the possible virtual boards with the three-dimensional model of the log, examination of how the defects are positioned along each virtual board, and estimation of how well each virtual board meets the quality criteria considered for the optimisation. In fact, once the value map 3 is provided (which can be laborious to obtain from a computational perspective, but is only performed before optimising the objective function and is not repeated in the course of the optimisation itself), the value at each point of interest is computed rather quickly.

For example, with reference to Figure 7, to obtain a cutting pattern of boards 2 with their minor face 21 having the dimensions and orientation as shown on the cross-section 12 of the three-dimensional model 19, the objective function is computed - for each considered combination of possible positions of the cuts - as the sum of the values of the respective virtual boards 25. It is therefore a matter of determining, on the cross-section 12, which arrangement of virtual boards 25 maximises the sum of the values computed from the value map 3. The arrangement that maximises this objective function is the cutting pattern to be implemented.

If, to obtain the cutting pattern, boards 2 must be considered which have minor faces 21 having different dimensions (i.e., as in Figure 6, the boards 2 do not all have the same dimensions) and/or different orientations (i.e., as in Figure 6, the minor faces do not all have the same orientation and/or it is desirable for the optimisation to also consider different orientations relative to the reference axis on the cross-section of the log), the first sub-step and the second sub-step are repeated for different orientations and/or different dimensions of the minor face: the different orientations of interest and the different dimensions of interest of the minor face 26 of a virtual board 25 are set and a respective value map 3 is provided for each combination of these. A plurality of value maps is thus obtained.

For example, Figure 8 shows four value maps for a same cross-section 12 of the same three-dimensional model 19: the value map 3a in the top left is for a minor face 26 having a first orientation and first dimensions; the value map 3b in the top right is for a minor face 26 having the first orientation and second dimensions (the width is greater than the width of the minor face with the first dimensions); the value map 3c in the bottom left is for a minor face 26 having a second orientation (rotated 90° relative to the first orientation) and the first dimensions; and the value map 3d in the bottom right is for a minor face 26 having the second orientation and the second dimensions.

In the third sub-step, the computation of the objective function uses different value maps to compute the value of virtual boards with minor faces oriented differently and/or with different dimensions: for example, with reference to Figure 8, for boards with the first orientation and the first dimensions, the value is provided by value map 3a, whereas for boards with the second orientation and the second dimensions, the value is provided by value map 3d.

In one possible embodiment, the first sub-step also sets a length along the longitudinal axis 10 and the second sub-step provides a value map of the virtual board 25 having that set length. In other words, the value map correlates to information about the features of the structure of the log 1 and/or about the defects of the log 1 only for a section having the set length and, therefore, the value map relates to a virtual board 25 having that set length.

This is the case, for example, when desiring to take into account possible increases in the value of the virtual board that can be achieved by removing end sections with major defects from the virtual board. This is an alternative to what has been described above in which the value map 3 already takes into account the higher value that could possibly be obtained by shortening the board.

For this purpose, value maps are considered which relate to cross-sections 12 spaced apart from each other (by "cutting off" sections at a first end of the virtual boards) and relate to different lengths along the longitudinal axis (by "cutting off" sections at a second end of the virtual boards).

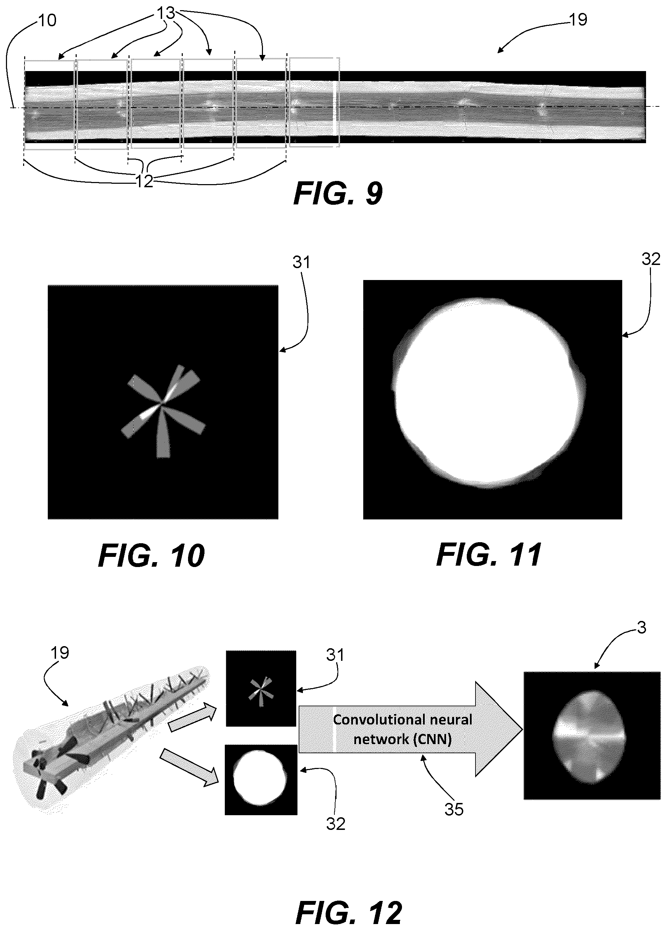

Specifically, as shown schematically in Figure 9, different cross-sections 12 of the three-dimensional model 19 of the log 1 are considered, which are spaced apart from each other, and for each of these cross-sections 12 value maps are provided relating to virtual boards 25 that have their minor face on the respective cross-section 12 and a respective set length. For obtaining the cutting pattern, this allows to take into account boards 2 with elongated faces 22 that have different lengths and/or with minor faces 21 not in a same plane transverse to the longitudinal axis 10, as shown in Figure 5.

In one possible embodiment of the step of the computer-processing of the three-dimensional model 19 of the log 1 to determine the cutting pattern, the plurality of combinations of possible positions of the cuts to be considered is produced using a generative neural network (which is known *per se*, whereas the application specific to this purpose is not known).

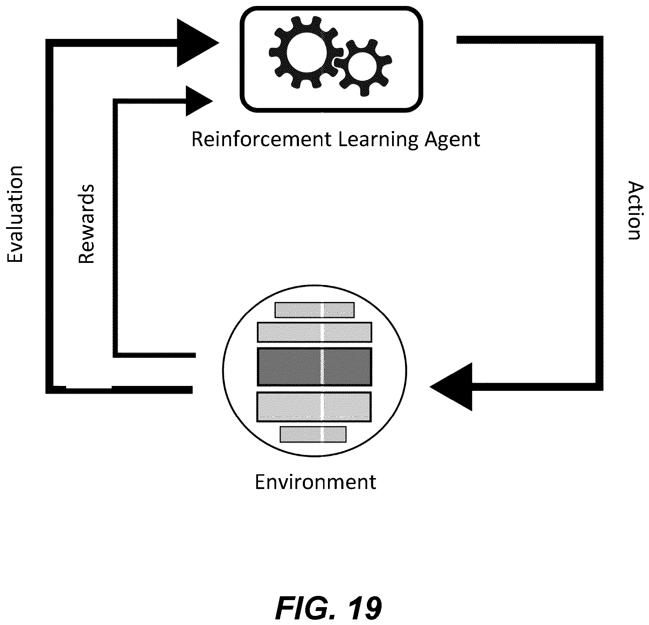

In one possible embodiment of the third sub-step, the optimisation of the objective function uses a reinforcement machine learning technique. In other words, the cutting solution tree is explored by this computerised technique that also implements machine learning. This is schematically illustrated in Figure 19, where the environment is represented by the possible cutting solutions. Reinforcement machine learning is in itself known in the prior art, whereas its application specific to this purpose is not known. One example of a reinforcement machine learning technique that is applicable here is described in: Chaofan Tu, Ruibin Bai, Uwe Aickelin, Yuchang Zhang, Heshan Du. A deep reinforcement learning hyper-heuristic with feature fusion for online packing problems. Expert Systems With Applications 230 (2023) 120568 (https:/Idoi.org/10.1016/j.eswa.2023.120568). Particular reference should be given to figure 1 of that article.

As regards obtaining the value map (or the value maps) in the second sub-step, in one particular embodiment the value map is obtained from a defect map 31 of the log and/or from a shape map 32 of the log. The defect map 31 and the shape map 32 are images (in electronic format) that are derived from the three-dimensional model 19 of the log 1 and relate to a section of predetermined length: defects of the section of the log (in particular internal defects such as knots 15, fissures, cracks) are represented in the defect map 31, while circumferential profiles of the section of the log are represented in the shape map 32.

This representation is a projection of the defects and of the circumferential profiles, respectively, onto a cross-section of the section of the log. See, for example, the defect map 31 in Figure 10 (which in particular is a knot map 15) and the shape map 32 in Figure 11.

To simplify: in the defect map 31, the black areas indicate regions of the considered section where no defects are present along a line perpendicular to the map, whereas the lighter the area the more defects are present; in the shape map 32, the white areas indicate regions of the considered section where a line perpendicular to the map lies entirely inside the log, whereas the darker the area the more the perpendicular line also lies outside the log (in fact, it should be kept in mind that the log 1 is not perfectly cylindrical and instead has variations of size, shape and curvature along the longitudinal axis 10). In practice, the shape map 32 can be regarded as a map for evaluating bevel defects.

If appropriate, the defect map 31 and the shape map 32 can be combined into a single map containing both sets of information or only the set of information of interest.

Multiple types of defect maps can be considered for a same type of defect to show different features of that defect. For knots, for instance, the features of interest that can be shown in different maps are the knot dimensions, number of knots per unit length, and classification as a live knot or a dead knot.

Where internal defects are not of interest and only the external shape of the log is considered (e.g. when the three-dimensional model of the log is obtained from a camera vision system), the value map is obtained only from the shape map 32.

In particular, when considering - to obtain the cutting pattern - boards 2 with elongated faces 22 that have different lengths and/or with minor faces 21 that are not in a same plane transverse to the longitudinal axis 10 (as discussed above, see for example Figure 5), or even just to quantify the value of the virtual boards 25 with greater accuracy, a plurality of defect maps 31 and/or a plurality of shape maps 32 are derived for the log 1 relating to successive sections 13 of the log 1 along the longitudinal axis 10. Specifically, as shown schematically in Figure 9, different cross-sections 12 of the three-dimensional model 19 of the log 1 are considered, which are spaced apart from each other by a section 13 having the predetermined length. The entire length of the three-dimensional model 19 of the log 1 is divided into sections 13; the respective defect map 31 and/or the shape map 32 is derived for each section 13; which is to say, these maps relate to sections 13 of the three-dimensional model 19 (and corresponding sections of the log 1) that are successive along the longitudinal axis 10.

Specifically, the predetermined length is in a range from 150 mm to 250 mm (e.g. 200 mm). The value of the predetermined length is selected by finding a compromise between, on the one hand, the precision of information about the longitudinal position of the defects and, on the other hand, the complexity of the input for the neural network. In the second sub-step, the value map is obtained from the plurality of defect maps and/or from the plurality of shape maps.

In these cases, the elongated face 27 of the virtual board 25 has a length greater (e.g. a multiple) than the predetermined length of the log section 13. For a virtual board 25 with a length shorter than the length of the three-dimensional model 19 of the log 1, the value map is obtained by considering the defect maps and/or shape maps only for the sections 13 traversed by the virtual board 25 and not for the end sections 13 to which the virtual board 25 does not extend.

Defect maps 31 and/or shape maps 32 relating to successive sections 13 along the longitudinal axis 10 are particularly useful for evaluating whether the value of the virtual board 25 increases by considering a board that is shorter and/or differently positioned along the longitudinal axis 10 instead of the virtual board with the maximum length; in other words, for evaluating the best obtainable value (see the description given above). To obtain the value map from a defect map of the log, inaccuracies in the three-dimensional model 19 of the log 1 (due to measurement errors of the tomography scanner 9 and/or processing inaccuracies) and/or inaccuracies of the cutting device can be taken into account. For this purpose, modified defect maps are computer-generated from the defect map obtained from the three-dimensional model 19 of the log.

The modified defect maps show the defects with their dimensions and/or positions altered relative to the defect map obtained from the three-dimensional model 19, the modifications being made based on statistical imprecision of the three-dimensional model and/or of the cutting device. The value map is obtained from the defect map and the modified defect maps.

In other words, the value map is obtained not only based on how the defects are located in the boards assuming that the three-dimensional model is correct and the cutting device is accurate, but also based on how these defects would be located in the boards if the defects were in positions deviating from those in the three-dimensional model and/or if the cutting device were to cut the log along cutting planes deviating from those in the cutting pattern. The weight given to the modified maps in obtaining the value map depends on the statistical inaccuracy of the three-dimensional model and/or of the cutting device: the greater the statistical inaccuracy, the greater the weight to be given to any larger deviations from the three-dimensional model. In practice, as in the Monte Carlo method and based on statistical error modelling, multiple "runs" obtaining the value map are made in order to generate a value evaluation that is statistically more robust. According to one particular embodiment, in the second sub-step, a convolutional neural network 35 is used to provide the value map 3 from the defect map 31 of the log and/or from the shape map 32 of the log. Specifically, the convolutional neural network 35 uses both the defect map 31 (or defect maps 31 for different characteristics - see the description above) and the shape map 32. This is schematically shown in Figure 12. For example, the convolutional neural network 35 has a U-net type architecture - see: Ronneberger Olaf, Fischer Philipp, Brox Thomas. "U-net: Convolutional networks for biomedical image segmentation." Medical Image Computing and Computer-Assisted Intervention-MICCAI 2015: 18th International Conference, Munich, Germany, October 5-9, 2015, Proceedings, Part III 18. Springer International Publishing, 2015.

The input of the convolutional neural network 35 for a single value map is a single image (e.g. with a size of 128 x 128 pixels) with several channels (even more than 200), where each channel corresponds to a defect map or a shape map of a certain log section. The output of the convolutional neural network is a single image (e.g. with a size of 128 x 128 pixels) containing the value map for specific dimensions and orientation of the minor face of the virtual boards, the convolutional neural network having been trained for such specific dimensions and orientation.

The present invention also concerns a training method for said convolutional neural network.

The training method first of all comprises a step of acquiring a set of three-dimensional models 19 of a plurality of logs 1. In particular, the number of logs 1 is more than 1000, specifically more than 3000.

The training method also comprises a step of generating training data. The step of generating training data in turn comprises, for each log 1 of said plurality of logs, a sub-step of processing the three-dimensional model 19 of the log 1 to compute the respective defect maps 31 and shape maps 32, and a sub-step of processing the three-dimensional model 19 of the log 1 to determine the value maps 3 of the virtual board 25 (in one or more cross-sections 12, according to how the method is implemented) by evaluating the virtual board 25 relative to the defects (internal and/or external) and circumferential profiles of the log 1.

In practice, in the training data generation stage, defect maps and shape maps are produced for the actual logs 1 (these maps are obtained from the respective three-dimensional models 19 of the logs 1) and are associated to the value maps that are processed based on the defects and circumferential profiles, for example by way of currently known methodologies in which the possible virtual boards are intersected with the three-dimensional model of the log obtained from the tomography scan, the positions of the defects along each virtual board are examined, and the value of each virtual board is estimated according to how well it meets the quality criteria to be considered for the optimisation. This processing is computationally demanding and can even take a very long time; however, it is performed only to generate the training data - that is, to tune the software of the manufacturing equipment - and not for the subsequent use of the manufacturing equipment in the sawmill, where the value map is computed by the trained convolutional neural network 35 in a small fraction of a second. In addition, the training processing can be performed using computers far more powerful than that of the manufacturing equipment in the sawmill.

The training method additionally comprises a step of training the convolutional neural network 35, wherein the input training data comprise the defect maps 31 and shape maps 32 for each log 1 of the plurality of logs, and the output training data are the corresponding value maps 3 for each log 1. The input data of the convolutional neural network 35 also comprise the orientation and dimensions of the minor face 26 of the virtual board 25 for which each value map 3 was computed.

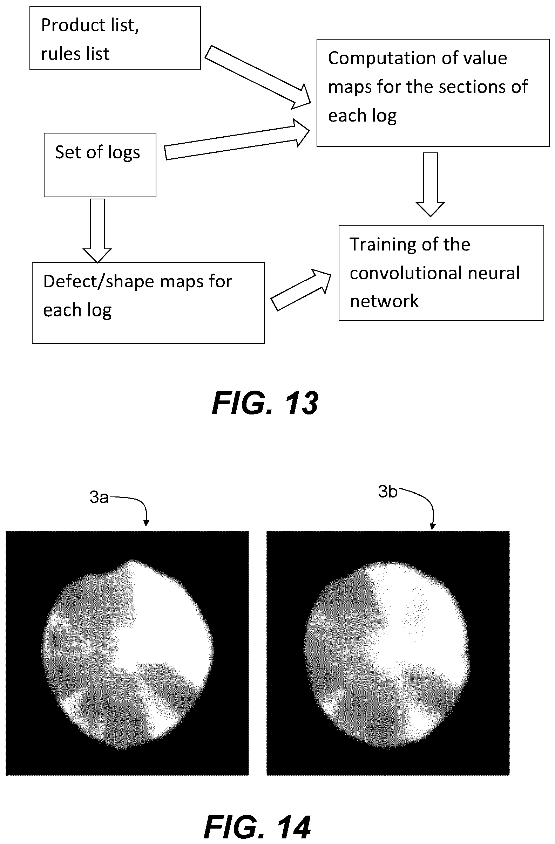

Figure 13 shows, by way of a block diagram, the method of training the convolutional neural network. From the set of logs 1, defect maps and shape maps are obtained for each log and, in combination with the list of products (i.e. the boards to be obtained, potentially with different dimensions from each other and different orientations) and the list of rules (i.e. the criteria for determining the value of the boards), value maps are also computed. The resulting data are used to train the convolutional neural network.

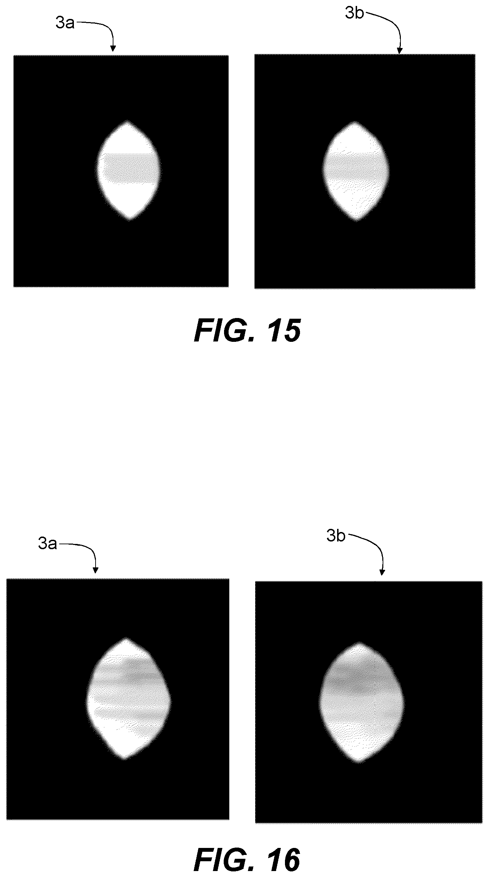

The inventors of the present invention trained the convolutional neural network 35 in the manner described above, where automatically generated data on a set of approximately 3500 randomly chosen logs were used for the training. The result is illustrated with the support of Figures 14 to 17, which show comparisons between value maps 3a used to train the convolutional neural network and corresponding value maps 3b computed by the trained convolutional neural network, for the same three-dimensional model of a log and for the same dimensions and orientation of the minor face of the virtual board. In each Figure, the image on the left is the training value map 3a and the image on the right is the computed value map 3b. It can be seen that the computed value maps 3b have very small deviations from the training value maps 3a and, therefore, the convolutional neural network 35 has been satisfactorily trained and reproduces the training data with reasonable precision.

Once training is complete, the convolutional neural network 35 can be used - in an essentially predictive mode - to compute the value map 3 after having inputted the defect map 31 and the shape map 32 obtained from the three-dimensional representation 19 for a new log 1.

The value map 3 is computed using the convolutional neural network 35 trained for the contemplated dimensions of the minor face of the virtual board. For different dimensions of the minor face of the virtual board, different convolutional neural networks 35 are used (e.g. with the same architecture but different values of the trained parameters). Where the orientation of the minor face of the virtual board is different from the training orientation of the convolutional neural network for the dimensions considered, the value map 3 can be computed using the correspondingly rotated defect map 31 and shape map 32 as inputs.

It thus becomes possible to provide an apparatus comprising a cutting device, a control system of the cutting device, and a computer. The cutting device comprises one or more blades and is capable of cutting a tree log 1 to obtain wooden boards 2. This is an apparatus, known per se in mechanical terms, that can be used in a sawmill.

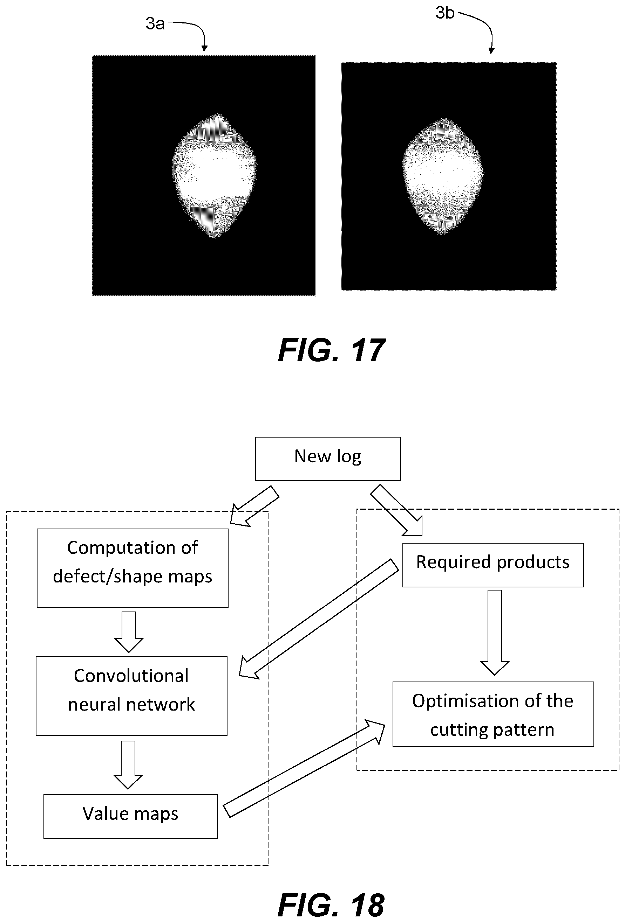

The computer is configured to implement the method according to the present invention, and in particular is configured to compute the cutting pattern using the value maps that are provided by the convolutional neural network trained as described above. See, for example, the block diagram in Figure 18.

The control system is operatively connected to the computer and is configured to control the cutting device in order to cut the log according to the cutting pattern provided by the computer.

The apparatus may also comprise a tomography scanner 9 in line with the cutting device, in such a way that the computed tomography scan of the log 1 and its three-dimensional model are obtained directly from the apparatus shortly before cutting.

Alternatively, the tomography scanner 9 can be separate from the apparatus, whose computer receives the three-dimensional model that was obtained separately.

Many modifications and variations can be made to the invention as designed herein without departing from the scope of protection as defined by the claims. All details may be substituted with other technically equivalent elements and the materials used, as well as the shapes and dimensions of the various components, may vary according to requirements, provided that they fall within the scope of the claims.

## Claims

1. A computer-implemented method to provide a cutting pattern for a tree log (1) to obtain wooden boards (2),
the log (1) extending along a longitudinal axis (10) and the cutting pattern relating to boards (2) each having a minor face (21) lying in a plane transverse to the longitudinal axis (10) and elongated faces (22) that are substantially parallel to the longitudinal axis (10), the cutting pattern comprising a set of positions of cuts substantially parallel to the longitudinal axis (10) for obtaining the elongated faces (22) of the boards (2),
wherein the method comprises:
- a step of obtaining a three-dimensional model (19) of the log (1), said three-dimensional model (19) containing information about features of a structure of the log (1) and/or about defects (15, 16, 17) of the log (1);
- a step of computer-processing of the three-dimensional model (19) of the log (1) to determine the cutting pattern, wherein a plurality of combinations of possible positions of cuts substantially parallel to the longitudinal axis (10) are considered and a value of an objective function is computed for each combination of possible positions, the objective function taking into account how the features and/or the defects (15, 16, 17) of the log (1) are positioned in virtual boards (25), the virtual boards (25) representing the boards that would be obtained from cutting according to the combination of possible positions, wherein the set of positions in the cutting pattern is chosen from the plurality of combinations by optimisation of the objective function;
**characterised in that** the step of computer-processing of the three-dimensional model (19) of the log (1) comprises:
- a first sub-step that sets an orientation and the dimensions of a minor face (26) of a virtual board (25);
- a second sub-step that, for a cross-section (12) of the three-dimensional model (19) of the log (1) that is transverse to the longitudinal axis (10) of the log (1), provides a value map (3) for the virtual board (25) having the minor face (26) with the set orientation and the set dimensions, the value map (3) assigning to each point of the cross-section (12) a value of the virtual board (25) that has the minor face (26) in a predetermined positional relationship with said point, in particular centred at said point, the value map (3) correlating to information about the features of the structure of the log (1) and/or about the defects (15, 16, 17) of the log (1);
- a third sub-step that optimises the objective function, wherein the computation of the objective function uses the value map (3) to compute the value of a virtual board (25) having the minor face (26), with the set orientation and the set dimensions, at the cross-section (12).

2. The method according to claim 1, wherein the first sub-step and the second sub-step are repeated for different orientations and/or different dimensions of the minor face (26), thus obtaining a plurality of value maps (3), and wherein the computation of the objective function uses different value maps (3) to compute the value of virtual boards (25) with minor faces (26) oriented differently and/or with different dimensions.

3. The method according to claim 1 or 2, wherein the first sub-step additionally sets a length along the longitudinal axis (10) and the second sub-step provides a value map (3) of the virtual board (25) having the set length.

4. The method according to any one of claims 1 to 3, wherein, in the second sub-step, the value map (3) is obtained from a defect map (31) of the log (1) and/or from a shape map (32) of the log (1), said defect map (31) and shape map (32) being images which are derived from the three-dimensional model (19) of the log (1) and relate to a section (13) of the log (1) of predetermined length, wherein defects (15, 16, 17) of the section (13) of log (1) are represented in the defect map (31) and circumferential profiles of the log (1) are represented in the shape map (32), this representation being a projection of the defects (15, 16, 17) and of the circumferential profiles, respectively, onto a cross-section (12) of the section (13) of log (1).

5. The method according to claim 4, wherein a plurality of defect maps (31) and/or a plurality of shape maps (32) which relate to successive sections (13) of the log (1) along the longitudinal axis (10) are derived for the log (1), whereby in the second sub-step the value map (3) is obtained from the plurality of defect maps (31) and/or from the plurality of shape maps (32).

6. The method according to claim 5, wherein the predetermined length of the section of log is in a range from 150 mm to 250 mm.

7. The method according to any one of claims 4 to 6, wherein, in order to obtain the value map (3) from a defect map (31) of the log (1), modified defect maps are generated from the defect map (31), the modified defect maps representing defects (15, 16, 17) with dimensions and/or positions modified relative to the defect map (31) based on a statistical inaccuracy of the three-dimensional model and/or of a cutting device, the value map (3) being obtained from the defect map (31) and from the modified defect maps.

8. The method according to any one of claims 4 to 7, wherein, in the second sub-step, a convolutional neural network (35) is used to provide the value map (3) from the defect map (31) of the log (1) and/or from the shape map (32) of the log (1).

9. The method according to claim 8, comprising a training method to train the convolutional neural network (35), the training method comprising:
- a step of acquiring a set of three-dimensional models (19) of a plurality of logs (1), said plurality of logs (1) in particular being greater in number than 1000 and, more in particular, being greater in number than 3000;
- a step of generating training data comprising, for each one of said plurality of logs (1), a sub-step of processing the three-dimensional model (19) of the log (1) to compute the respective defect maps (31) and shape maps (32), and a sub-step of processing the three-dimensional model (19) of the log (1) to determine the value maps (3) of the virtual board (25) by evaluating the virtual board (25) relative to the defects (15, 16, 17) and to the circumferential profiles of the log (1);
- a step of training the convolutional neural network (35), wherein the input training data comprise the defect maps (31) and the shape maps (32) for each log (1) of the plurality of logs, and the output training data are the corresponding value maps (3) for each log (1).

10. The method according to any one of claims 1 to 9, wherein, in the step of computer-processing of the three-dimensional model (19) of the log (1) to determine the cutting pattern, the plurality of combinations of possible positions of cuts to be considered is produced using a generative neural network.

11. The method according to any one of claims 1 to 10, wherein, in the third sub-step, the optimisation of the objective function uses a reinforcement machine learning technique.

12. The method according to any one of claims 1 to 11, wherein the step of obtaining the three-dimensional model (19) of the log (1) comprises computed tomography scanning of the log.

13. An apparatus comprising a cutting device, a cutting device control system and a computer,
wherein the cutting device comprises one or more blades and is capable of cutting a tree log (1) to obtain wooden boards (2), the computer is configured to implement the method according to any one of claims 1 to 12, and the control system is operatively connected with the computer and is configured to control the cutting device in order to cut the log (1) according to the cutting pattern provided by the computer.

14. A training method to train a convolutional neural network (35) which provides a value map (3) from a defect map (31) of a tree log (1) and/or from the shape map (32) of the log (1),
the defect map (31) and the shape map (32) being images derived from a three-dimensional model (19) of the log (1) which contains information about features of a structure of the log (1) and/or about defects (15, 16, 17) of the log (1),
the defect map (31) and the shape map (32) relating to a section (13) of the log (1) of predetermined length, wherein defects (15, 16, 17) of the section (13) of log (1) are represented in the defect map (31) and circumferential profiles of the log (1) are represented in the shape map (32), this representation being a projection of the defects (15, 16, 17) and of the circumferential profiles, respectively, onto a cross-section (12) of the section (13) of log (1),
the value map (3) correlating to information about the features of the structure of the log (1) and/or about the defects (15, 16, 17) of the log (1), the value map (3) assigning to each point of the cross-section (12) a value of a virtual board (25) having a minor face (26) which has a set orientation and set dimensions and which is in a predetermined positional relationship with said point, in particular is centred at said point,
wherein the training method comprises:
- a step of acquiring a set of three-dimensional models (19) of a plurality of logs (1), said plurality of logs (1) in particular being greater in number than 1000 and, more in particular, being greater in number than 3000;
- a step of generating training data comprising, for each one of said plurality of logs (1), a sub-step of processing the three-dimensional model (19) of the log (1) to compute the respective defect maps (31) and shape maps (32), and a sub-step of processing the three-dimensional model (19) of the log (1) to determine the value maps (3) of the virtual board (25) by evaluating the virtual board (25) relative to the defects (15, 16, 17) and to the circumferential profiles of the log (1);
- a step of training the convolutional neural network (35), wherein the input training data comprise the defect maps (31) and the shape maps (32) for each log (1) of the plurality of logs, and the output training data are the corresponding value maps (3) for each log (1).

## Patentansprüche

1. Ein computerimplementiertes Verfahren zur Bereitstellung eines Schnittmusters für einen Baumstamm (1), um Holzbretter (2) zu erhalten,
der Stamm (1) erstreckt sich dabei auf eine Längsachse (10) und das Schnittmuster bezieht sich dabei auf Bretter (2), von denen jedes eine kleinere Seitenfläche (21), die dabei auf einer Ebene quer zur Längsachse (10) liegt, und längliche Seitenflächen (22), die im Wesentlichen parallel zur Längsachse (10) sind, hat, das Schnittmuster beinhaltet dabei eine Reihe von Schnittpositionen, im Wesentlichen parallel zur Längsachse (10), um die länglichen Seitenflächen (22) der Bretter (2) zu erhalten,
wobei das Verfahren Folgendes beinhaltet:
- einen Schritt des Erhaltens eines dreidimensionalen Modells (19) des Stamms (1), besagtes dreidimensionales Modell (19) enthält dabei Informationen über Merkmale einer Struktur des Stamms (1) und/oder über Defekte (15, 16, 17) des Stamms (1);
- einen Schritt der Computerverarbeitung des dreidimensionalen Modells (19) des Stamms (1), um das Schnittmuster festzulegen, wobei eine Mehrzahl von Kombinationen möglicher Schnittpositionen, im Wesentlichen parallel zur Längsachse (10), in Betracht gezogen werden und für jede Kombination möglicher Positionen ein Wert einer objektiven Funktion berechnet wird, die objektive Funktion berücksichtigt dabei, wie die Merkmale und/oder die Defekte (15, 16, 17) des Stamms (1) in virtuellen Brettern (25) positioniert sind, die virtuellen Bretter (25) stellen dabei die Bretter dar, die erhalten würden, wenn nach der Kombination möglicher Positionen geschnitten würde, wobei die Reihe von Positionen im Schnittmuster aus der Mehrzahl von Kombinationen durch Optimierung der objektiven Funktion ausgewählt wird;
**dadurch gekennzeichnet, dass** der Schritt der Computerverarbeitung des dreidimensionalen Modells (19) des Stamms (1) Folgendes beinhaltet:
- einen ersten Unterschritt, der eine Ausrichtung und die Maße einer kleineren Seitenfläche (26) eines virtuellen Bretts (25) festsetzt;
- einen zweiten Unterschritt, der für einen Querschnitt (12) des dreidimensionalen Modells (19) des Stamms (1), der quer zur Längsachse (10) des Stamms (1) ist, eine Wertekarte (3) für das virtuelle Brett (25), das dabei die kleinere Seitenfläche (26) mit der festgesetzten Ausrichtung und den festgesetzten Maßen hat, bereitstellt, die Wertekarte (3) weist dabei jedem Punkt des Querschnitts (12) einen Wert des virtuellen Bretts (25) zu, das die kleinere Seitenfläche (26) in einem vorher festgelegten Positionsverhältnis zu besagtem Punkt hat, namentlich an besagtem Punkt zentriert, die Wertekarte (3) korreliert dabei mit Informationen über die Merkmale der Struktur des Stamms (1) und/oder über die Defekte (15, 16, 17) des Stamms (1);
- einen dritten Unterschritt, der die objektive Funktion optimiert, wobei die Berechnung der objektiven Funktion die Wertekarte (3) verwendet, um den Wert eines virtuellen Bretts (25), das dabei die kleinere Seitenfläche (26) mit der festgesetzten Ausrichtung und den festgesetzten Maßen hat, am Querschnitt (12) zu berechnen.

2. Das Verfahren nach dem Patentanspruch 1, wobei der erste Unterschritt und der zweite Unterschritt für unterschiedliche Ausrichtungen und/oder unterschiedliche Maße der kleineren Seitenfläche (26) wiederholt werden, wodurch eine Mehrzahl von Wertekarten (3) erhalten wird, und wobei die Berechnung der objektiven Funktion verschiedene Wertekarten (3) verwendet, um den Wert virtueller Bretter (25) mit kleineren Seitenflächen (26), die dabei unterschiedlich ausgerichtet sind und/oder unterschiedliche Maße haben, zu berechnen.

3. Das Verfahren nach dem Patentanspruch 1 oder 2, wobei der erste Unterschritt zusätzlich eine Länge auf der Längsachse (10) festsetzt und der zweite Unterschritt eine Wertekarte (3) des virtuellen Bretts (25), das dabei die festgesetzte Länge hat, bereitstellt.

4. Das Verfahren nach jedem der Patentansprüche 1 bis 3, wobei im zweiten Unterschritt die Wertekarte (3) aus einer Defektekarte (31) des Stamms (1) und/oder aus einer Formkarte (32) des Stamms (1) erhalten wird, besagte Defektekarte (31) und Formkarte (32) sind dabei Bilder, die von dem dreidimensionalen Modell (19) des Stamms (1) abgeleitet wurden und sich auf einen Abschnitt (13) des Stamms (1) mit vorher festgelegter Länge beziehen, wobei Defekte (15, 16, 17) des Abschnitts (13) des Stamms (1) in der Defektekarte (31) dargestellt sind und Umfangsprofile des Stamms (1) in der Formkarte (32) dargestellt sind, diese Darstellung ist dabei eine Projektion der Defekte (15, 16, 17) beziehungsweise der Umfangsprofile auf einen Querschnitt (12) des Abschnitts (13) des Stamms (1).

5. Das Verfahren nach dem Patentanspruch 4, wobei eine Mehrzahl von Defektekarten (31) und/oder eine Mehrzahl von Formkarten (32), die sich auf aufeinander folgende Abschnitte (13) des Stamms (1) auf der Längsachse (10) beziehen, für den Stamm (1) abgeleitet werden, wobei im zweiten Unterschritt die Wertekarte (3) aus der Mehrzahl von Defektekarten (31) und/oder aus der Mehrzahl von Formkarten (32) erhalten wird.

6. Das Verfahren nach dem Patentanspruch 5, wobei die vorher festgelegte Länge des Stammabschnitts in einem Bereich zwischen 150 mm und 250 mm liegt.

7. Das Verfahren nach jedem der Patentansprüche 4 bis 6, wobei, um die Wertekarte (3) aus einer Defektekarte (31) des Stamms (1) zu erhalten, veränderte Defektekarten aus der Defektekarte (31) erzeugt werden, die veränderten Defektekarten stellen dabei Defekte (15, 16, 17) mit veränderten Maßen und/oder Positionen im Verhältnis zur Defektekarte (31) auf der Grundlage einer statistischen Ungenauigkeit des dreidimensionalen Modells und/oder des Schnittgeräts dar, die Wertekarte wird dabei aus der Defektekarte (31) und aus den veränderten Defektekarten erhalten.

8. Das Verfahren nach jedem der Patentansprüche 4 bis 7, wobei im zweiten Unterschritt ein neuronales Faltungsnetz (35) verwendet wird, um die Wertekarte (3) aus der Defektekarte (31) des Stamms (1) und/oder aus der Formkarte (32) des Stamms (1) bereitzustellen.

9. Das Verfahren nach dem Patentanspruch 8, ein Trainingsverfahren beinhaltend, um das neuronale Faltungsnetz (35) zu trainieren, das Trainingsverfahren beinhaltet dabei Folgendes:
- einen Schritt der Erfassung einer Reihe von dreidimensionalen Modellen (19) einer Mehrzahl von Stämmen (1), besagte Mehrzahl von Stämmen (1) hat dabei im Einzelnen eine Zahl von mehr als 1000 und hat insbesondere eine Zahl von mehr als 3000;
- einen Schritt der Erzeugung von Trainingsdaten, der dabei für jede einzelne der besagten Mehrzahl von Stämmen (1) einen Unterschritt der Verarbeitung des dreidimensionalen Modells (19) des Stamms (1), um die Defektekarten (31) beziehungsweise Formkarten (32) zu berechnen, und einen Unterschritt der Verarbeitung des dreidimensionalen Modells (19) des Stamms, um die Wertekarten (3) des virtuellen Bretts (25) durch Auswertung des virtuellen Bretts (25) in Bezug auf die Defekte (15, 16, 17) und die Umfangsprofile des Stamms (1) festzulegen, beinhaltet;
- einen Schritt des Trainierens des neuronalen Faltungsnetzes (35) wobei die Eingangstrainingsdaten die Defektekarten (31) und die Formdaten (32) für jeden Stamm (1) der Mehrzahl von Stämmen beinhalten und die Ausgangstrainingsdaten die entsprechenden Wertekarten (3) für jeden Stamm (1) sind.

10. Das Verfahren nach jedem der Patentansprüche 1 bis 9, wobei im Schritt der Computerverarbeitung des dreidimensionalen Modells (19) des Stamms (1), um das Schnittmuster festzulegen, die Mehrzahl von Kombinationen möglicher Schnittpositionen, die in Betracht zu ziehen sind, unter Verwendung eines generativen neuronalen Netzes erstellt wird.

11. Das Verfahren nach jedem der Patentansprüche 1 bis 10, wobei im dritten Unterschritt die Optimierung der objektiven Funktion eine Technik des bestärkenden Lernens (Reinforcement Machine Learning) verwendet.

12. Das Verfahren nach jedem der Patentansprüche 1 bis 11, wobei der Schritt des Erhaltens des dreidimensionalen Modells (19) des Stamms (1) eine Computertomographie des Stamms beinhaltet.

13. Eine Vorrichtung, die ein Schnittgerät, ein Schnittgerätsteuerungssystem und einen Computer beinhaltet,
wobei das Schnittgerät eine oder mehrere Klingen beinhaltet und dazu imstande ist, einen Baumstamm (1) zu zerschneiden, um Holzbretter (2) zu erhalten, der Computer dazu eingerichtet ist, das Verfahren nach jedem der Patentansprüche 1 bis 12 zu implementieren und das Steuerungssystem operativ mit dem Computer verbunden ist und dazu eingerichtet ist, das Schnittgerät zu steuern, um den Stamm (1) nach dem Schnittmuster zu schneiden, das vom Computer bereitgestellt wird.

14. Ein Trainingsverfahren, um ein neuronales Faltungsnetz (35) zu trainieren, das eine Wertekarte (3) aus einer Defektekarte (31) eines Baumstamms (1) und/oder aus der Formkarte (32) des Baumstamms (1) bereitstellt, die Defektekarte (31) und die Formkarte (32) sind dabei Bilder, die aus einem dreidimensionalen Modell des Stamms (1), das Informationen über Merkmale einer Struktur des Stamms (1) und/oder über Defekte (15, 16, 17) des Stamms (1) enthält, abgeleitet wurden, die Defektekarte (31) und die Formkarte (32) beziehen sich dabei auf einen Abschnitt (13) des Stamms (1) mit einer vorher festgelegten Länge, wobei Defekte (15, 16, 17) des Abschnitts (13) des Stamms (1) in der Defektekarte (31) dargestellt sind und Umfangsprofile des Stamms (1) in der Formkarte (32) dargestellt sind, diese Darstellung ist dabei eine Projektion der Defekte (15, 16, 17) beziehungsweise der Umfangsprofile auf einen Querschnitt (12) des Abschnitts (13) des Stamms (1),
die Wertekarte (3) korreliert dabei mit Informationen über die Merkmale der Struktur des Stamms (1) und/oder über die Defekte (15, 16, 17) des Stamms (1), die Wertekarte (3) weist dabei jedem Punkt des Querschnitts (12) einen Wert eines virtuellen Bretts (25) zu, das dabei eine kleinere Seitenfläche (26) hat, die eine festgesetzte Ausrichtung und festgesetzte Maße hat und die in Bezug auf ihre Position ein vorher festgelegtes Verhältnis zu besagtem Punkt hat, namentlich an besagtem Punkt zentriert ist,
wobei das Trainingsverfahren Folgendes beinhaltet:
- einen Schritt des Erfassens einer Reihe dreidimensionaler Modelle (19) einer Mehrzahl von Stämmen (1), besagte Mehrzahl von Stämmen (1) hat dabei im Einzelnen eine größere Zahl als 1000 und insbesondere eine größere Zahl als 3000;
- einen Schritt der Erzeugung von Trainingsdaten, der dabei für jede der besagten Mehrzahl von Stämmen (1) einen Unterschritt der Verarbeitung des dreidimensionalen Modells (19) des Stamms (1), um die Defektekarten (31) beziehungsweise Formkarten (32) zu berechnen, und einen Unterschritt der Verarbeitung des dreidimensionalen Modells (19) des Stamms (1), um die Wertekarten (3) des virtuellen Bretts (25) durch Auswertung des virtuellen Bretts (25) in Bezug auf die Defekte (15, 16, 17) und die Umfangsprofile des Stamms (1) festzulegen, beinhaltet;
- einen Schritt des Trainierens des neuronalen Faltungsnetzes (35), wobei die Eingangstrainingsdaten die Defektekarten (31) und die Formkarten (32) für jeden Stamm (1) der Mehrzahl von Stämmen beinhalten und die Ausgangstrainingsdaten die entsprechenden Wertekarten (3) für jeden einzelnen Stamm (1) sind.

## Revendications

1. Un procédé mis en œuvre par ordinateur pour fournir un schéma de coupe d'un tronc d'arbre (1) afin d'obtenir des planches en bois (2),
le tronc (1) s'étendant le long d'un axe longitudinal (10) et le schéma de coupe concernant des planches (2) ayant, chacune, une petite face (21) située dans un plan transversal à l'axe longitudinal (10) et des faces allongées (22) qui sont essentiellement parallèles à l'axe longitudinal (10), le schéma de coupe comprenant un ensemble de positions de coupes essentiellement parallèles à l'axe longitudinal (10) pour obtenir les faces allongées (22) des planches (2),
dans lequel le procédé comprend :
- une étape consistant à obtenir un modèle tridimensionnel (19) du tronc (1), ledit modèle tridimensionnel (19) contenant des informations sur des caractéristiques d'une structure du tronc (1) et/ou sur des défauts (15, 16, 17) du tronc (1) ;
- une étape consistant à traiter par ordinateur le modèle tridimensionnel (19) du tronc (1) pour déterminer le schéma de coupe, au cours de laquelle une pluralité de combinaisons de positions possibles de coupes essentiellement parallèles à l'axe longitudinal (10) sont considérées et une valeur d'une fonction objectif est calculée pour chaque combinaison de positions possibles, la fonction objectif tenant compte de la manière dont les caractéristiques et/ou les défauts (15, 16, 17) du tronc (1) sont positionnés dans des planches virtuelles (25), les planches virtuelles (25) représentant les planches qui seraient obtenues de la coupe selon la combinaison de positions possibles, où l'ensemble de positions dans le schéma de coupe est choisi dans la pluralité de combinaisons par optimisation de la fonction objectif ;
**caractérisé en ce que** l'étape de traitement par ordinateur du modèle tridimensionnel (19) du tronc (1) comprend :
- une première sous-étape qui définit une orientation et les dimensions d'une petite face (26) d'une planche virtuelle (25) ;
- une deuxième sous-étape qui, pour une section transversale (12) du modèle tridimensionnel (19) du tronc (1) qui est transversale à l'axe longitudinal (10) du tronc (1), fournit une carte de valeur (3) pour la planche virtuelle (25) ayant la petite face (26) avec l'orientation définie et les dimensions définies, la carte de valeur (3) attribuant à chaque point de la section transversale (12) une valeur de la planche virtuelle (25) qui a la petite face (26) dans une relation positionnelle prédéfinie avec ledit point, en particulier centrée au niveau dudit point, la carte de valeur (3) étant corrélée aux informations sur les caractéristiques de la structure du tronc (1) et/ou sur les défauts (15, 16, 17) du tronc (1) ;
- une troisième sous-étape qui optimise la fonction objectif, au cours de laquelle le calcul de la fonction objectif utilise la carte de valeur (3) pour calculer la valeur d'une planche virtuelle (25) ayant la petite face (26), avec l'orientation définie et les dimensions définies, au niveau de la section transversale (12).

2. Le procédé selon la revendication 1, dans lequel la première sous-étape et la deuxième sous-étape sont répétées pour différentes orientations et/ou différentes dimensions de la petite face (26), obtenant ainsi une pluralité de cartes de valeur (3), et dans lequel le calcul de la fonction objectif utilise différentes cartes de valeur (3) pour calculer la valeur de planches virtuelles (25) avec des petites faces (26) orientées différemment et/ou avec des dimensions différentes.

3. Le procédé selon la revendication 1 ou 2, dans lequel la première sous-étape définit en outre une longueur le long de l'axe longitudinal (10) et la deuxième sous-étape fournit une carte de valeur (3) de la planche virtuelle (25) ayant la longueur définie.

4. Le procédé selon l'une quelconque des revendications de 1 à 3, dans lequel, dans la deuxième sous-étape, la carte de valeur (3) est obtenue à partir d'une carte de défauts (31) du tronc (1) et/ou à partir d'une carte de forme (32) du tronc (1), lesdites carte de défauts (31) et carte de forme (32) étant des images qui sont dérivées du modèle tridimensionnel (19) du tronc (1) et concernent un tronçon (13) du tronc (1) de longueur prédéfinie, dans lequel des défauts (15, 16, 17) du tronçon (13) du tronc (1) sont représentés dans la carte de défauts (31) et des profils circonférentiels du tronc (1) sont représentés dans la carte de forme (32), cette représentation étant une projection des défauts (15, 16, 17) et des profils circonférentiels, respectivement, sur une section transversale (12) du tronçon (13) du tronc (1).

5. Le procédé selon la revendication 4, dans lequel une pluralité de cartes de défauts (31) et/ou une pluralité de cartes de forme (32) qui concernent des tronçons successifs (13) du tronc (1) le long de l'axe longitudinal (10) sont dérivées pour le tronc (1), ce par quoi, dans la deuxième sous-étape, la carte de valeur (3) est obtenue à partir de la pluralité de cartes de défauts (31) et/ou à partir de la pluralité de cartes de forme (32).

6. Le procédé selon la revendication 5, dans lequel la longueur prédéfinie du tronçon de tronc est comprise dans la plage allant de 150 mm à 250 mm.

7. Le procédé selon l'une quelconque des revendications de 4 à 6, dans lequel, afin d'obtenir la carte de valeur (3) à partir d'une carte de défauts (31) du tronc (1), des cartes de défauts modifiées sont générées à partir de la carte de défauts (31), les cartes de défauts modifiées représentant des défauts (15, 16, 17) avec des dimensions et/ou des positions modifiées par rapport à la carte de défauts (31) sur la base d'une imprécision statistique du modèle tridimensionnel et/ou d'un dispositif de coupe, la carte de valeur (3) étant obtenue à partir de la carte de défauts (31) et à partir des cartes de défauts modifiées.

8. Le procédé selon l'une quelconque des revendications de 4 à 7, dans lequel, dans la deuxième sous-étape, un réseau neuronal convolutif (35) est utilisé pour fournir la carte de valeur (3) à partir de la carte de défauts (31) du tronc (1) et/ou à partir de la carte de forme (32) du tronc (1).

9. Le procédé selon la revendication 8, comprenant un procédé d'entraînement pour entraîner le réseau neuronal convolutif (35), le procédé d'entraînement comprenant :
- une étape consistant à acquérir un ensemble de modèles tridimensionnels (19) d'une pluralité de troncs (1), ladite pluralité de troncs (1) étant en particulier supérieure en nombre à 1 000 et, plus particulièrement, étant supérieure en nombre à 3 000 ;
- une étape consistant à générer des données d'entraînement comprenant, pour chaque tronc de ladite pluralité de troncs (1), une sous-étape de traitement du modèle tridimensionnel (19) du tronc (1) pour calculer les cartes de défauts (31) et cartes de forme (32) respectives, et une sous-étape de traitement du modèle tridimensionnel (19) du tronc (1) pour déterminer les cartes de valeur (3) de la planche virtuelle (25) en évaluant la planche virtuelle (25) par rapport aux défauts (15, 16, 17) et aux profils circonférentiels du tronc (1) ;
- une étape consistant à entraîner le réseau neuronal convolutif (35), au cours de laquelle les données d'entraînement en entrée comprennent les cartes de défauts (31) et les cartes de forme (32) pour chaque tronc (1) de la pluralité de troncs, et les données d'entraînement en sortie sont les cartes de valeur (3) correspondantes pour chaque tronc (1).

10. Le procédé selon l'une quelconque des revendications de 1 à 9, dans lequel, dans l'étape de traitement par ordinateur du modèle tridimensionnel (19) du tronc (1) pour déterminer le schéma de coupe, la pluralité de combinaisons de positions possibles de coupes à considérer est produite en utilisant un réseau neuronal génératif.

11. Le procédé selon l'une quelconque des revendications de 1 à 10, dans lequel, dans la troisième sous-étape, l'optimisation de la fonction objectif utilise une technique d'apprentissage automatique par renforcement.

12. Le procédé selon l'une quelconque des revendications de 1 à 11, dans lequel l'étape consistant à obtenir le modèle tridimensionnel (19) du tronc (1) comprend une tomographie informatisée du tronc.

13. Un appareil comprenant un dispositif de coupe, un système de commande du dispositif de coupe et un ordinateur,
dans lequel le dispositif de coupe comprend une ou plus lames et est destiné à couper un tronc d'arbre (1) pour obtenir des planches en bois (2), l'ordinateur est configuré pour mettre en œuvre le procédé selon l'une quelconque des revendications de 1 à 12, et le système de commande est opérationnellement relié à l'ordinateur et est configuré pour commander le dispositif de coupe de manière à couper le tronc (1) selon le schéma de coupe fourni par l'ordinateur.

14. Un procédé d'entraînement pour entraîner un réseau neuronal convolutif (35) qui fournit une carte de valeur (3) à partir d'une carte de défauts (31) d'un tronc d'arbre (1) et/ou à partir de la carte de forme (32) du tronc (1),
la carte de défauts (31) et la carte de forme (32) étant des images dérivées d'un modèle tridimensionnel (19) du tronc (1) qui contient des informations sur des caractéristiques d'une structure du tronc (1) et/ou sur des défauts (15, 16, 17) du tronc (1),
la carte de défauts (31) et la carte de forme (32) concernant un tronçon (13) du tronc (1) de longueur prédéfinie, dans lequel des défauts (15, 16, 17) du tronçon (13) de l'arbre (1) sont représentés dans la carte de défauts (31) et des profils circonférentiels du tronc (1) sont représentés dans la carte de forme (32), cette représentation étant une projection des défauts (15, 16, 17) et des profils circonférentiels, respectivement, sur une section transversale (12) du tronçon (13) de l'arbre (1),
la carte de valeur (3) étant corrélée aux informations sur les caractéristiques de la structure du tronc (1) et/ou sur les défauts (15, 16, 17) du tronc (1), la carte de valeur (3) attribuant à chaque point de la section transversale (12) une valeur d'une planche virtuelle (25) ayant une petite face (26) qui a une orientation définie et des dimensions définies et qui est dans une relation positionnelle prédéfinie avec ledit point, en particulier centrée au niveau dudit point,
dans lequel le procédé d'entraînement comprend :
- une étape consistant à acquérir un ensemble de modèles tridimensionnels (19) d'une pluralité de troncs (1), ladite pluralité de troncs (1) étant en particulier supérieure en nombre à 1 000 et, plus particulièrement, étant supérieure en nombre à 3 000 ;
- une étape consistant à générer des données d'entraînement comprenant, pour chaque tronc de ladite pluralité de troncs (1), une sous-étape de traitement du modèle tridimensionnel (19) du tronc (1) pour calculer les cartes de défauts (31) et cartes de forme (32) respectives, et une sous-étape de traitement du modèle tridimensionnel (19) du tronc (1) pour déterminer les cartes de valeur (3) de la planche virtuelle (25) en évaluant la planche virtuelle (25) par rapport aux défauts (15, 16, 17) et aux profils circonférentiels du tronc (1) ;
- une étape consistant à entraîner le réseau neuronal convolutif (35), au cours de laquelle les données d'apprentissage en entrée comprennent les cartes de défauts (31) et les cartes de forme (32) pour chaque tronc (1) de la pluralité de troncs, et les données d'entraînement en sortie sont les cartes de valeur (3) correspondantes pour chaque tronc (1).
